# EUROPEAN PATENT APPLICATION

(11) **EP 2 538 752 A1**
(43) Date of publication of application: **26.12.2012**
(21) Application number: 11744751.6
(22) Date of filing: 18.02.2011
(51) Int. Cl.: H05B 33/04, G02F 1/1333, G02F 1/1339, H01L 31/042, H01L 51/50, H05B 33/02

(54) **SEALED FUNCTIONAL ELEMENT**

(30) Priority: 18.02.2010 JP 2010033207
(71) Applicant: Mitsui Chemicals Tohcello, Inc., Tokyo 101-8485 (JP)
(72) Inventor: NAKAMURA, Osamu, Koga-shi Ibaraki 306-0213 (JP)
(74) Representative: Raynor, Stuart Andrew
(86) International application number: PCT/JP2011/053509
(87) International publication number: WO 2011/102465

(57) **Abstract**

The present invention provides a sealed function element obtainable by sealing a function element, for example, a liquid crystal display element, an element such as an organic EL and the like, and an organic function element such as a sheet like luminous illuminant, an optical device and a solar cell, reliably by a convenient step, particularly it provides a thin type sealed function element having a long life.

The sealed function element comprises a substrate layer (W), a function element layer (X) and a laminated film for sealing (Z) wherein the substrate layer (W) and a heat-sealing thermoplastic resin layer (E) of the laminated film for sealing (Z) are adhered and unified by heat-sealing. The laminated film for sealing comprises the heat-sealing thermoplastic resin layer (E), a water-absorbing layer (F) and a gas barrier layer (G) which layers are laminated in this order.

## Description

### TECHNICAL FIELD

The present invention relates to a sealed function element, which is reliably sealed by a convenient step, applied for liquid crystal display elements, elements such as an organic EL and the like, and organic function elements such as a sheet like luminous illuminant, an optical device and a solar cell, particularly it relates to a sealed function element capable of being made into a thin type element.

### TECHNICAL BACKGROUND

An organic EL is used for cellular phones, watches and displays as a slim lightweight sheet-like luminous illuminant which is easy on the eye. However, the luminous quantity of the organic EL is lowered by moisture absorption caused by the outside. On this account, the organic EL is sealed with a gas barrier film in order to keep a stable luminous quantity for a long period of time.

Furthermore, it is known that a plastic film is used for sealing the organic EL and the organic EL is sealed by heat sealing. (Patent document 1, Patent document 2 and Patent document 3).

These plastic films are desired to have transparency such that a display part can be visually confirmed and surface smoothness. Moreover, in order to prevent deterioration of an element part formed on an EL substrate, a film having gas barrier properties such as excellent interception properties for oxygen and water vapor and free from pinhole has been desired.

Recently, there is a demand that function elements including an organic element such as an organic EL element and other elements be slimed and made into a small size. Furthermore, sealed function elements also have a demand of being slimed.

### CITATION LIST

### Patent document

Patent document 1: JP-A-H5-36475, Column 37
Patent document 2: JP-A-H8-167475, Column 19
Patent document 3: JP-A-2001-237065, Column 23

### SUMMARY OF THE INVENTION

### SUBJECT TO BE SOLVED BY THE INVENTION

It is an object of the present invention to provide a sealed function element which is reliably sealed by heat-sealing, can be slimed and made into a small size, and examples of the function element are an organic EL, a solar cell and other function elements.

### MEANS FOR SOLVING THE SUBJECT

That is to say, the present invention relates to a sealed function element composed of a substrate layer (W), a function element (X) and a laminated film for sealing (Z) wherein the substrate layer (W) and a heat-sealing thermoplastic resin layer (E) of the laminated film for sealing (Z) are adhered and unified.

In the preferred embodiment of the present invention, the laminated film for sealing (Z) is composed of a gas barrier layer (G) and the heat-sealing thermoplastic resin layer (E). In the further preferred embodiment, the laminated film for sealing (Z) comprises the heat-sealing thermoplastic resin layer (E), a water-absorbing layer (F) and the gas barrier layer (G) which layers are laminated in this order.

As the substrate layer (W), a glass substrate, a gas barrier film layer or a metal thin plate provided with an insulating layer are preferred.

In the present invention, the substrate layer (W) and the laminated film for sealing (Z) are preferably adhered and unified on the surrounding part or the whole surface by heat sealing of the heat sealing thermoplastic resin layer (E).

The gas barrier film layer used in the present invention is preferably composed of a transparent substrate film (Wa), an inorganic thin film layer (Wb) or no inorganic thin film layer, and a transparent resin layer (Wc) containing a polymer comprising unsaturated carboxylic acid and/or its derivative, which are laminated in this order.

### EFFECT OF THE INVENTION

The sealed function element of the present invention is reliably sealed by a convenient heat sealing step, particularly, when the gas barrier film is used, the resulting function element has a long lifetime and also the sealed function element can be slimed.

### BRIEF DESCRIPTION OF THE DRAWING

Fig. 1 is a cross sectional view of a sealed function element schematically shown according to the present invention.
Fig. 2 is a cross sectional view of another sealed function element schematically shown according to the present invention.
Fig. 3 is a cross sectional view of still another sealed function element schematically shown according to the present invention.
Fig. 4 is a cross sectional view of a further sealed function element schematically shown according to the present invention.
Fig. 5 is a cross sectional view of a still further sealed function element schematically shown according to the present invention.
Fig. 6 is a cross sectional view of a furthermore sealed function element schematically shown according to the present invention.
Fig. 7 is a cross sectional view of a still furthermore sealed function element schematically shown according to the present invention.
Fig. 8 is a cross sectional view of a moreover sealed function element schematically shown according to the present invention.

### EMBODIMENT FOR CARRYING OUT THE INVENTION

The sealed function element of the present invention is composed of a substrate layer (W), a function element (X) and a laminated film for sealing (Z) and is characterized in that the substrate layer (W) and a heat-sealing thermoplastic resin layer (E) of the laminated film for sealing (Z) are adhered and unified by heat sealing.

The material of the heat-sealing thermoplastic resin layer (E) is not particularly limited as long as a function element can be sealed by fusion bonding with the substrate layer (W). The function element (W) is a device which is desired to be highly sealed, and examples thereof are a liquid crystal element, an element such as organic EL, and an organic function element such as a sheet-like light emitting device, an optical device and a solar cell.

The function element (X) is usually provided on the surface of the substrate layer (W), but may be provided on the surface of the laminated film for sealing (Z).

The laminated film for sealing (Z) may be previously unified with the heat-sealing thermoplastic resin layer (E), but after sealing and unification, at least one part of the laminated film for sealing (Z) may be bonded to heat-sealing thermoplastic resin layer (E) by heat-sealing the function element.

Therefore, in the sealed function element of the present invention, the heat-sealing thermoplastic resin layer (E) may be provided on at least part to be heat sealed and it is unnecessary that the heat-sealing thermoplastic resin layer (E) is provided on the whole surface. Furthermore, before heat-sealing, it is unnecessary that as the laminated film for sealing (Z), the heat sealing thermoplastic resin layer (E) is unified, and during the production, they are laminated and formed successively. From the viewpoint of production efficiency of the sealed function element of the present invention, as the laminated film for sealing (Z) the heat-sealing thermoplastic resin layer (E) is preferably unified previously before heat sealing.

The sealed function element of the present invention will be described with reference to the drawings.

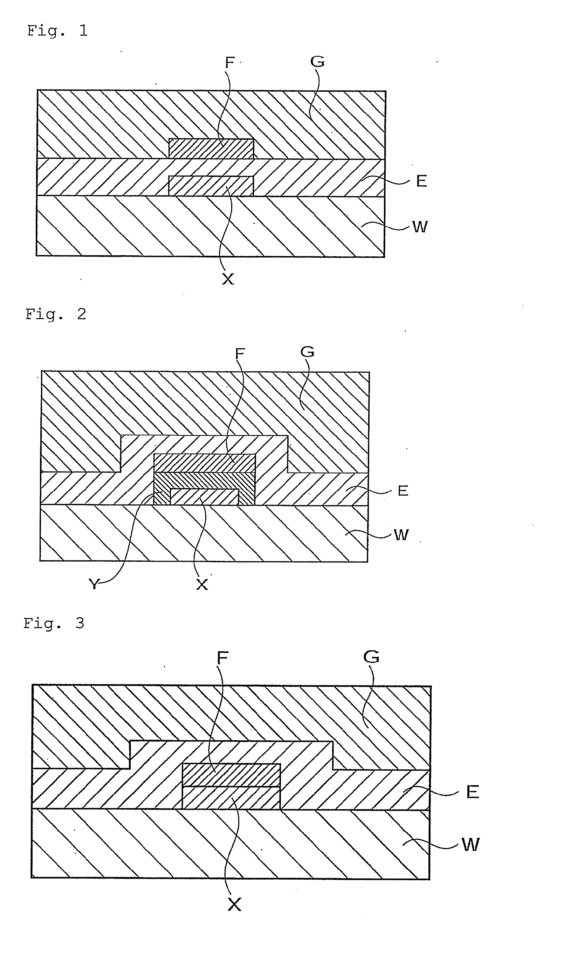

Fig. 1 is a cross sectional view of schematically showing a preferable example of the sealed function element of the present invention.

The favorable sealed function element as shown in Fig. 1 is composed of a substrate layer (W), a function element layer (X), and a laminated film for sealing (Z) containing a heat-sealing thermoplastic resin layer (E) and a water-absorbing layer (F).
The heat-sealing thermoplastic resin layer (E) is formed so as to fill the space between the function element (X) and the water-absorbing layer (F), and the heat-sealing thermoplastic resin layer (E) is provided until the end part for heating sealing the sealed function element. Since the heat-sealing thermoplastic resin layer (E) is formed so as to fill the space of the substrate layer (W), the function device (X) and the water-absorbing layer (F), even when the water-absorbing layer (F) damages the function element (X) by contacting with the function element, the function element (X) can be prevented from contacting.

Moreover, in the case that the sealed function element is formed in a large size, when there is a space (gap) between the water-absorbing layer (F) and the function element (X), or between the heat-sealing thermoplastic resin layer (E) and the gas barrier layer (G), the stress unbalance of the gas barrier layer (G) is caused and the gas barrier layer (G) is sometimes deformed to the direction to which the gap is filled with time. Since there is a possibility that the function element does not sufficiently work by deformation of the gas barrier layer (G), the large size formation of the function element is sometimes difficult. For example, when an organic EL is sealed as a function element, it has a possibility that emission of light is uneven by deformation of the gas barrier layer (G). Therefore, it is necessary to seal in order that such a gap is not formed in the present invention. The sealing can be reliably performed by the present invention.

It is unnecessary to prepare the laminated film for sealing (Z) for constituting the sealed function element of the present invention previously as described in the above. On the substrate layer (W), the function element (X), the heat-sealing thermoplastic resin layer (E) and the gas barrier layer (G) are placed in this order and heat sealed to prepare the laminated film for sealing (Z).

In the production of the sealed function element according to the present invention, since the sealed function element needs to have a structure that there is no gap between the gas barrier layer (G) and the substrate layer (X), it is preferred to carry out vacuum treatment before heat sealing.

The production process of the sealed function element of the present invention will be described below with the specific examples.

Each of Figures 1 to 8 shows a cross sectional view of the sealed function element schematically shown according to the invention.
In the sealed function element of Figure 1, on the flat substrate layer (W), the function element layer (X) is adhered and placed, the laminated film for sealing (Z) is covered and laminated thereon and thereby the substrate layer (W) and the heat sealing thermoplastic resin layer (E) are adhered and unified by heat sealing.

The laminated film for sealing (Z) comprises the gas barrier layer (G) and the heat sealing thermoplastic resin layer (E), preferably comprises the heat sealing thermoplastic resin layer (E), the water-absorbing layer (F) and the gas barrier layer (G). On the whole surface of the laminated film for sealing (Z), the heat sealing thermoplastic resin layer (E) may be provided, or on only the periphery part surrounding the function element provided on the substrate layer (W), the heat sealing thermoplastic resin layer (E) may be provided.

The surface of the substrate layer (W) and the surface of the heat sealing thermoplastic resin layer (E) of the laminated film for sealing (Z) are adhered and vacuum treated, and then heat sealed by pressing a heating bar or a heating roll on the periphery part or the whole surface of the substrate layer (W). The substrate layer (W) and the heat sealing thermoplastic resin layer (E) of the laminated film for sealing (Z) are adhered and fitted, and then the heat sealing thermoplastic resin layer (E) is heated and melted by pushing a heating mean such as a heating bar or a heating roll from one side or the both sides on the periphery or on the whole surface of them and thereby the substrate layer (glass substrate, glass thin film, gas barrier film layer or the like) and the laminated film for sealing (Z) can be firmly adhered and unified.

In the case of unifying the substrate layer (W) and the laminated film for sealing (Z) by heat sealing, it is necessary to not damage the function element. Depending on the kind of the function element, it is usually preferred that the temperature of the surface of the function element is not higher than 120°C.

It is particularly preferred that at the time of heat sealing, the thermoplastic resin of the heat sealing thermoplastic resin layer (E) heated is forced out from the end part of the laminated film for sealing (Z) to form a protruded part and thereby the part or whole cross sectional part between the gas barrier layer (G) and the substrate layer (W) is covered with the heat sealing thermoplastic resin layer (E). Even if this protruded part is formed temporarily at the time of forcing out in the heat sealing, the cross sectional part can be covered. It is considered that when the protruded part formed temporarily at the time of forcing out in the heat sealing is returned into a flat part, some of the resin constituting the heat sealing thermoplastic resin layer (E) remains on the cross sectional part to cover the part.

In the heat-sealing, there are ferroelectric heating using microwave, ultrasonic heating and a method of using laser beam in addition to the method of using a heating bar or a heating roll.

When the function element layer (X) side surface of the substrate layer (W) is superposed on the surface of the heat sealing thermoplastic resin layer (E) of the laminated film for sealing (Z) and a heating bar is pressed thereon from the one side or the both sides, it is preferred to employ a heating method of using a heating bar having a square shape in order to heat seal the periphery of the four sides of the function element layer (X) at the same time from the viewpoint of production efficiency.

The sealed function element of the present invention may have a filling layer (Y) provided on the side surface and/or the surface of the function element.

The filling layer (Y) is desirably provided on the side surface and/or the surface of the function element. The filling layer (Y) protects the function element from moisture according to the position thereof, prevents the sealed function element from deformation and also prevents the surface of the function element from contacting with the water-absorbing layer (F). Furthermore, in the case that the filling layer (Y) is provided in order to protect the function element from moisture, it is preferably provided on the side surface periphery part of the function element. Moreover, in the case that the filling layer (Y) is provided in order to prevent the sealed function element from deformation, it is preferably provided in such a way that it connects between the substrate layer (W) or the surface of the function element and the laminated film for sealing (Z).
In the case that the filling layer (Y) is provided in order to prevent the function element surface from contacting with the water-absorbing layer (F), the filling layer (Y) is preferably provided between the function element and the water-absorbing layer (F).
Fig. 2 is a cross sectional view of the sealed function element schematically shown according to the present invention.
In Fig. 2, the filling layer (Y) is provided on the side surface and the surface of the function element. The filling layer (Y) provided on the surface of the functional element fills in the space between the filling layer (Y) and the water-absorbing layer (F). This embodiment is particularly preferred, because the sealed function element has excellent shape stability, the function element surface is prevented from contact with the water-absorbing layer (F) and the function element is prevented from moisture.

In the present invention, it is possible to use a gas barrier film layer and a metal foil laminated film as well as the glass substrate as the substrate layer (W).
Each of Figs. 3 to 8 shows a cross sectional view of another sealed function element schematically shown according to the present invention.

In Fig. 3, the water absorbing layer (F) and the function element layer (X) are adjacently provided each other. Furthermore, the heat-sealing thermoplastic resin layer (E) is provided so as to cover the peripheries of the water absorbing layer (F) and the function element layer (X). In the preferred embodiment of the sealed function element of the present invention, since the function element layer (X) and the water absorbing layer (F) are adjoined, the damage caused by moisture which will be a factor for damaging the function element is effectively prevented.

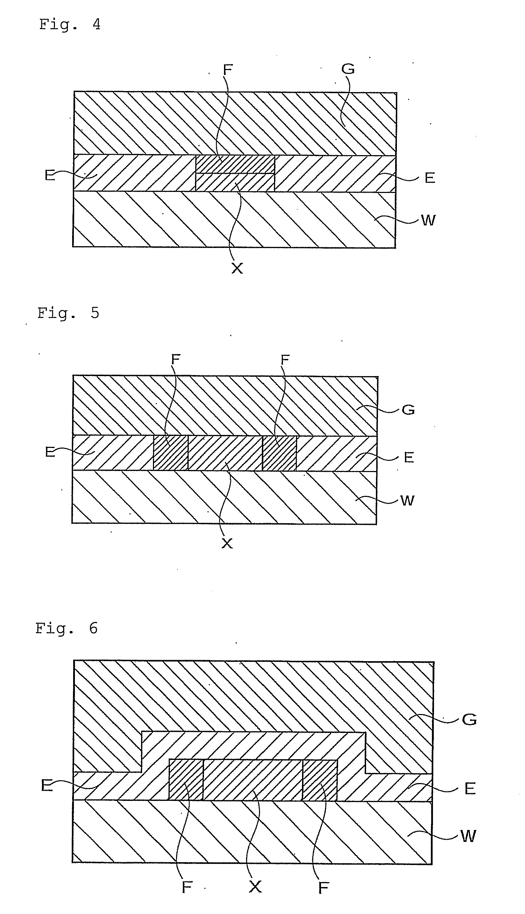

In Fig. 4, the heat-sealing thermoplastic resin layer (E) is provided only on the side periphery part of the function element and the function element layer (X) and the water-absorbing layer (F) are provided to be adjoined. In the preferred embodiment of the sealed function element of the present invention, since the function element layer (X) and the water absorbing layer (F) are adjoined, the damage caused by moisture which will be a factor for damaging the function element is effectively prevented and also the flat sealed function element can be reliably prepared.
In Fig. 5, the heat-sealing thermoplastic resin layer (E) is provided only on the periphery part of the function element and the water absorbing layer (F) is provided on the side of the function element. In the sealed function element, although there is a possibility that moisture inters into the heat sealing thermoplastic resin layer (E), the water-absorbing layer (F) catches moisture before moisture reaches to the function element layer (X). Therefore, the function element can be effectively prevented from damage caused by moisture.
In Fig. 6, the heat-sealing thermoplastic resin layer (E) is provided on the whole surface of the function element and the water-absorbing layer (F) is provided only on the side surface of the function element. In the sealed function element of the present invention, since the water-absorbing layer (F) catches moisture entered from the heat-sealing thermoplastic resin layer (E) before moisture reaches to the function element layer (X), the function element can be effectively prevented from damage caused by moisture. Furthermore, since the heat-sealing thermoplastic resin layer (E) is provided on the whole surface, the sealed function element can be more firmly and stably fixed. Moreover, since it is unnecessary to conduct such a pre-treatment of notching a film which will be made into the heat-sealing thermoplastic resin layer (E) in the production of the sealed function element, the production efficiency is good.

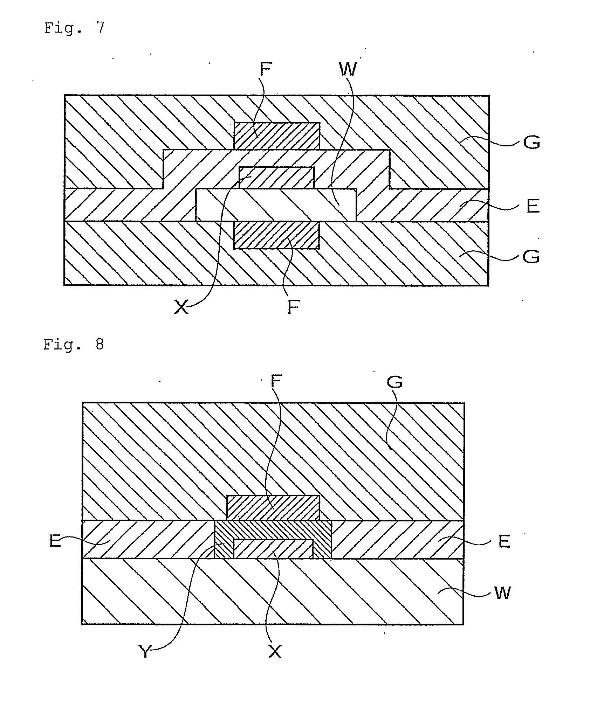

In Fig. 7, the substrate layer (W) is covered with the gas barrier layer (G) from the side of the function element (X) and on the other side of the substrate layer (W), the gas barrier layer (G) is provided. Furthermore, the water-absorbing layer (F) is provided on both gas barrier layers (G), i.e. on two positions, and the heat sealing thermoplastic resin layer (E) is provided on the whole surface so as to fill the gap of the substrate layer (W), the function element, the gas barrier layer (G) and the water-absorbing layer (F). Since the sealed function element has the water-absorbing layer (F) on the both sides of the function element, the function element can be effectively prevented from damage caused by moisture. Moreover, since the substrate layer (W) is provided on the gas barrier layer (G), the sealed function element can have flexibility.
Fig. 8 is the embodiment as same as that in Fig. 2 except that the heat-sealing thermoplastic resin layer (E) is not provided on the part of the water-absorbing layer (F). Since on the heat-sealing thermoplastic resin layer (F) into which moisture will enter, the water-absorbing layer (F) is provided and the function element is covered with the filling layer (Y), the moisture and gas-shielding effect is very high and the function element can be effectively protected from damage caused by moisture or gases. In the case that the sealed function element needs to have light transmitting properties from outside, one side or the both sides of the water-absorbing layer (F) preferably have light transmitting properties according to the kind of light emitting function elements or function elements.

### Laminated film for sealing (Z)

The laminated film for sealing (Z) is a laminated film having gas barrier properties and heat-sealing properties. On this account, the laminated film for sealing (Z) preferably has the gas barrier layer (G) and the heat-sealing thermoplastic resin layer (E).

In the preferred embodiment of the present invention, the sealed function element has the laminated film for sealing (Z) obtainable by laminating the heat-sealing thermoplastic resin layer (E), the water-absorbing layer (F) and the gas barrier layer (G) in this order. Since the laminated film for sealing (Z) has this structure, an absorbing agent of the water-absorbing layer (F) does not contact with the function element (X) and thereby the function element can be kept in isolation. Therefore, in the case of organic EL, an element of the organic EL does not contact with a water-absorbing layer directly and occurrence of dark spots can be prevented in the organic EL.

For the gas barrier layer (G) constituting the laminated film for sealing (Z), various gas barrier films and metal thin films can be used.
Examples of the gas barrier films are films obtainable by using sol-gel and films obtainable by using an acryl monomer and it is possible to use materials selected from the gas barrier films used as the substrate layer (W), as described below.

In the case of using a metal foil film as the gas barrier layer (G), the kind of the metals is not particularly limited. Examples of the metal are copper, brass, copper alloy, aluminum, stainless steel, tin and nickel. Among them, aluminum foil and stainless steel foil are preferred. The metal foil has a thickness of usually 5 to 200 µm, preferably 6 to 100 µm. These metal foils may be formed by a chemical vapor deposition method, a physical vapor deposition method or sputtering.

Examples of a thermoplastic resin used in the heat-sealing thermoplastic resin layer (E) constituting the laminated film for sealing (Z) are not particularly limited as long as the object of the present invention is not impaired, for example, the function element is not damaged by outgas at the time of heat sealing with the substrate layer (W). Preferable examples of the thermoplastic resin are low-density polyethylene, LLDPE which is a random copolymer of ethylene and an α-olefin of 4 o 8 carbon atoms, an ethylene/α-olefin copolymer elastomer such as ethylene/propylene copolymer, ethylene/1-butene copolymer, ethylene/1-hexene copolymer and 1-octene copolymer, a propylene elastomer such as propylene/ethylene copolymer and propylene/ethylene/1-butene copolymer, a butene elastomer such as butene/ethylene copolymer, and a copolymer of ethylene and a polar monomer such as ethylene/vinyl acetate copolymer and ethylene/acrylic acid copolymer.

These, furthermore, may be modified with an acrylic acid, a maleic acid, an anhydrous maleic acid or a polar group-containing monomer such as an epoxy group-containing monomer.

The heat-sealing thermoplastic resin layer (E) has a thickness of usually 0.5 to 300 µm, preferably 1 to 100 µm.

Examples of the method of laminating the heat-sealing thermoplastic resin layer (E) are a method of laminating with lamination and a method of laminating as a coat layer with coating.

Examples of a coating agent are ionomers such as ethylene-vinyl acetate copolymer, ethylene-acrylic acid copolymer, ethylene-sodium methacrylate copolymer.

As described above, as the thermoplastic resin used for the heat-sealing thermoplastic resin layer (E), any one can be used without particular limitation as long as it can be melted and adhered on other materials. However, it is necessary to avoid a resin which generates gases at the time of heating and melting and has a harmful effect on the function element layer (X). Preferable examples are acrylic acid, anhydrous maleic acid and polyolefins obtainable by grafting their derivatives, such as polyethylene and polypropylene.

The materials constituting the filling layer (Y) used in the sealed function element of the present invention are not particularly limited as long as the object of the present invention is not impaired, for example, the function element is not damaged. Examples thereof are a thermoplastic resin, an ultraviolet ray curing resin such as epoxy acrylate and urethane acrylate, an ionizing radiation curing resin and a thermosetting resin, and further an inorganic substance such as calcium oxide and an adhesive material such as elastomer and the like.
Moreover, the filling layer (Y) may comprise a resin having water-absorbing properties.
Using the material of the water-absorbing layer (F) for the filling layer (Y), it is possible to add water-absorbing properties, and the heat-sealing thermoplastic resin layer (E) constituting the laminated film for sealing (Z) can be provided as the filling layer (Y).
Examples of the water-absorbing agent used for the water-absorbing layer (F) are not particularly limited as long as they do not mar the object of the present invention. Examples thereof are known a moisture-absorbing agent and a compound capable of reacting with water such as an organic metal compound and a powdery inorganic oxide having an average particle diameter of not more than 90 µm, i.e. barium oxide, calcium oxide and strontium oxide.

In the present invention, the laminated film for sealing (Z) is previously prepared in one unit by laminating the heat-sealing thermoplastic resin layer (E), the water-absorbing layer (F) and the gas barrier layer (G) in this order and then the sealed function element can be prepared using the laminated film together with the substrate layer (W) and the function element layer (X). Moreover, at first, the heat-sealing thermoplastic resin layer (E) is laminated to the substrate layer (W) and the function element (X), and the water-absorbing layer (F) is provided thereon and further the gas barrier layer (G) is provide so as to cover them, followed by heat sealing.

### Functional device layer (X)

In the function element layer (X), the function element is a device which is required to have high sealing properties. Examples of the function element are liquid crystal display elements, elements such as organic EL, organic function elements such as sheet-like light emitting devices, light devices and solar cells and inorganic function elements such as inorganic EL and other devices.

### Substrate layer (W)

Examples of the substrate layer (W) are a glass substrate, a glass thin film, a gas barrier film, a metal foil laminated film, and other materials having gas barrier properties. The gas barrier film is preferably used as the substrate layer (W), because the processing is easy and simple.

### Gas barrier film

As the gas barrier layer (G) or the gas barrier film for forming the substrate layer (W), various known gas barrier films can be used. Among them, the gas barrier film is preferably a laminated film obtainable by laminating a transparent substrate film (Wa), an inorganic thin film layer (Wb) and a transparent resin layer (Wc) in this order. Another example of the gas barrier film is a laminated film which does not have the inorganic thin film layer (Wb) and comprises the transparent substrate film (Wa) and the transparent resin layer (Wc).

Hereinafter, each layer of the preferred gas barrier film will be described.

### Transparent substrate film (Wa)

The transparent substrate film (Wa), which is a gas barrier film, comprises a polyolefin resin such as polyethylene, polypropylene and poly-4-methyl-1-pentene, and a resin having transparent properties such as polystyrene, polyethylene terephthalate (PET), polynaphthalene terephthalate (PEN), polysulfone, polyether sulfone, polyester, polymethyl methacrylate, polycarbonate, polyarylate, polyacetate and polyamide resin. The film may be an unstitched film or a film stretched in the mono-axial or bi-axial direction.

The transparent substrate film (Wa) constituting the gas barrier film has a thickness of usually about 10 µm to 250 µm, and the thickness thereof is determined according to the use in consideration of self-supporting properties, handling properties and impact resistance of the film.

### Inorganic thin film layer (Wb)

The inorganic thin film layer (Wb) comprises a single substance of an oxide, nitride or fluoride of silicon, aluminum, titanium, zirconium, tin, magnesium or indium, or a composite substance thereof. Particularly, since aluminum oxide is colorless and transparent, and has excellent properties such as resistance to boiling and retorting, it can be used in various uses.

The method of forming the inorganic thin film layer (Wb) is not particularly limited. Various methods can be employed, and examples of the methods are chemical vapor deposition method, physical vapor deposition method and sputtering. The inorganic thin film layer is preferably formed on the transparent substrate film (Wa).

In order to prepare the film having excellent surface smoothness, the bonding reaction of the surface of the transparent substrate film (Wa) and an inorganic atom, an inorganic molecule or an inorganic compound is preferably conducted rapidly in forming the transparent inorganic thin film. In order to conduct the bonding reaction rapidly, the inorganic atom, the inorganic moisture and the inorganic compound preferably have a free radical and are chemically active molecule species or atom species from the viewpoint of barrier properties.

As the film forming method, the chemical vapor deposition method, the physical vapor deposition method and sputtering are preferred. Among them, the chemical gas phase vapor deposition method (CVD method) is preferred. Using the method, the surface of the transparent substrate film resin layer (Wa) and the chemically active molecule species containing silicon such as silicon nitride or oxidized silicon nitride can be reacted rapidly, the smoothness of the surface of the inorganic thin film layer (Wb) is improved and enhanced and thereby fine pores generated on the surface can be decreased.

Among the CVD methods, it is preferred to employ a catalyst CVD method (Cat CVD method) such that gas molecules are decomposed and activated by heating element to form a film on the substrate. According to this method, the fine transparent inorganic thin film can be prepared and further, the film having excellent gas barrier properties and low stress, namely flexibility can be formed.

The inorganic thin film layer (Wb) of the present invention has a thickness of usually 5 to 500 nm, preferably 10 to 200 nm from the viewpoint of gas barrier properties and flexibility capable of keeping gas barrier properties.

### Transparent resin layer (Wc)

The transparent resin layer (Wc) of the present invention preferably comprises a polymer which comprises unsaturated carboxylic acid and/or its derivative in order to have excellent barrier properties. A polymer prepared from unsaturated carboxylic acid and/or its derivative with polymerization may be applied on the transparent substrate film (Wa) or preferably applied on the inorganic thin film layer (Wb) in order to have stability of barrier properties.

Furthermore, unsaturated carboxylic acid and/or its derivative are applied on the transparent substrate film (Wa) or the inorganic thin film layer (Wb) and then the coated layer is radial polymerized by peroxide crosslinking or ultraviolet ray crosslinking to prepare a polymer coated layer.

Examples of unsaturated carboxylic acid and/or its derivative are unsaturated carboxylic acids having a degree of polymerization of less than 20, derivatives of their polyvalent metal salts and an epoxy acrylate compound.

In order to previously apply unsaturated carboxylic acid having a degree of polymerization of less than 20 and/or a derivative of its polyvalent metal salt on the transparent substrate film (Wa), preferably the inorganic thin film layer (Wb), it is preferred that a solution containing these compounds be applied and then unsaturated carboxylic acid and/or its derivative contained in the solution be polymerized by a radical initiator or ultraviolet ray to form the transparent resin layer (Wb).

### Unsaturated carboxylic acid

Examples of unsaturated carboxylic acid are preferably carboxylic acids having α,β-ethylenic unsaturated group such as acrylic acid, methacrylic acid, maleic acid or itaconic acid. The degree of polymerization thereof is less than 20, preferably not more than 10. Among these unsaturated carboxylic acids, a completely neutralized salt having a monomer of a polyvalent metal compound is preferred because it is easily formed and the film obtainable by polymerizing the salt has excellent gas barrier properties.

### Polyvalent metal compound

Examples of the polyvalent metal compound used in the preparation of the polyvalent metal salt of unsaturated carboxylic acid are metals having two or more valences such as magnesium (Mg), calcium (Ca), barium (Ba), zinc (Zn) and copper (Cu), mono-valent metals such as lithium (Li), sodium (Na) and potassium (K), and oxides, hydroxides, halides, carbonates, phosphates, phosphites, hypophosphites, sulfates and sulfites of these metals. Among these metal compounds, the bi-valent metal compounds are preferred, and further, magnesium oxide, calcium oxide, barium oxide, zinc oxide, magnesium hydroxide, calcium hydroxide, barium hydroxide and zinc hydroxide are particularly preferred. When these bi-valent metal compounds are used, the resulting film obtainable by polymerizing the salt of unsaturated carboxylic acid has more excellent gas barrier properties at a high humidity. At least one of these compounds is used or two or more may be used in combination.

### Polyvalent metal salt of unsaturated carboxylic acid

The polyvalent metal salt of unsaturated carboxylic acid is a salt of unsaturated carboxylic acid having a degree of polymerization of less than 20 and the above polyvalent metal compound. One kind of the polyvalent metal salts of unsaturated carboxylic acid or a mixture thereof may be used. Among the polyvalent metal salts of unsaturated carboxylic acid, zinc (meth)acrylate is preferred because the resulting gas barrier properties-having film has excellent hot water resistance.

### Epoxy acrylate compound

Examples of the epoxy acrylate compound are bisphenol A-type epoxy acrylate, 1,4-butanediol diglycidyl ether diacrylate, 1,6-hexane diol diglycidyl ether diacrylate, diethyleneglycol diglycidyl ether diacrylate, dipropylene glycol diglycidylether diacrylate, phenol novolac type epoxy acrylate, carboxylic acid anhydride modified epoxy acrylate, cresol novolac type epoxy acrylate.

### Production process of transparent resin layer (Wc)

The transparent resin layer (Wc) is preferably produced by polymerizing unsaturated carboxylic acid and/or its derivative which have been previously applied on the transparent substrate film (Wa), preferably on the inorganic thin film layer (Wb). The film-like transparent resin layer (Wc) formed by polymerization is preferably heat-treated.

Examples of the method of applying the solution of unsaturated carboxylic acid and/or its derivative on the transparent substrate film (Wa), preferably the inorganic thin film layer (Wb) are known coating methods such as air knife coater and direct gravure coater.

To the polyvalent metal salt solution of unsaturated carboxylic acid, polyvinyl alcohol and the like can be added in order to improve peeling strength and add flexibility to the film.

### Heat treatment of transparent resin layer (Wc)

The transparent resin layer (Wc) prepared by polymerization is preferably heat-treated in order to improve barrier properties.

The heat treatment for the transparent resin layer (Wc) is carried out at a temperature of usually 30 to 350° C, preferably 60 to 300° C, more preferably 150 to 250° C, in an inert gas atmosphere. The pressure is not particularly limited, and the heat treatment is carried out in any one condition of under pressure, under reduce pressure and under ordinary pressure. Examples of the heat treatment method are heating with oven, heating with roll and heating with far-infrared rays. The time for the heat treatment differs depending on the heat treatment method. For example, in the heating with oven, the time is usually about from 30 sec to 90 min, preferably 1 min to 70 min, more preferably 5 min to 60 min.

With regard to the heat treatment, the transparent resin layer (Wc) is prepared by polymerization and then may be heat-treated successively or after the temperature of the film is returned to ordinary temperature. It is usually preferred to carry out the step of forming the film by polymerization and the step of heat treatment continuously from the viewpoint of production efficiency.

It is considered that the film structure of the transparent resin layer (Wc) for heat treatment is determined by polymerization. The transparent resin layer (Wc) is further heat treated and thereby made into a stabilized film having more stabilized gas barrier properties by dehydration and partial relocation of the film structure.

The thickness of the transparent resin layer (Wc) is determined in accordance with the production cost and surface smoothness, which are necessary for various uses without particular limitation. The thickness is usually from 0.1 to 20 µm, preferably 0.1 to 10 µm.

Providing the transparent resin layer (Wc) improves the adhesion between the transparent substrate film (Wa) and the inorganic thin film layer (Wc) and the gas barrier properties can be improved.

Moreover, the gas barrier film comprises other layers without marring the object of the present invention. Examples of the other layers are a transparent metal thin film layer and a transparent metal oxide layer. The transparent substrate film (Wa) and the transparent resin layer (Wb) may be submitted to corona treatment or plasma treatment. The combined use thereof can add reflection preventing properties and glare preventing properties.

In the present invention, when the function element is a light emitting or image-receiving device, a glass substrate is used as the substrate layer (W), and further a gas barrier film having the same structure as that of the gas barrier layer (G) and a metal foil laminate film are used. The gas barrier film layer used in the substrate layer (W) has a visible light transmissivity of preferably not less than 70 %, more preferably not less than 85 %. Although the upper limit of the visible light transmissivity is 100 %, it is commonly not more than 95 % in view of surface reflection and absorption of the materials. Furthermore, when the function element is a light emitting or image-receiving device, the gas barrier film of the present invention has an average roughness Ra of preferably 0 to 1 nm, more preferably 0 to 0.5 nm per 1 µm² area from the viewpoint of light emitting or light-receiving stability.

### EXAMPLE

Organic EL will be described below as the sealed function element of the present invention.

A glass thin plate (thickness: 0.7 mm) for the substrate layer (W) and an organic EL device for the function element layer (X) are used.

The gas barrier layer (G) constituting the laminated film for sealing (Z) comprises a thin film prepared by a sol-gel method, a gas barrier layer prepared from an unsaturated carboxylic acid metal salt by UV crosslinking, inorganic vapor deposition layer, or the like.

As the heat-sealing thermoplastic resin layer (E) constituting the laminated film for sealing, a layer (thickness 30 µm) which comprises a modified polyolefin (melting point 139° C) containing a polar group-containing monomer such as acrylic acid, maleic acid, anhydrous maleic acid and epoxy group-containing monomer is used.

Between the gas barrier layer (G) and the heat-sealing thermoplastic resin layer (E), a moisture getter sheet (manufactured by Dynic Corporation) is inserted as a water-absorbing layer.

Using them, the organic EL device is disposed on the glass thin plate, and the laminated film for sealing is superimposed on the glass thin plate so that the heat-sealing thermoplastic resin layer is super-positioned on the glass thin plate, and a heating bar (170° C) is pressed on the periphery part of the organic EL device from the side of the laminated film for sealing with the result that the surface of the heat-sealing thermoplastic resin layer is heat-sealed on the glass thin plate.

After the organic EL device thus sealed is placed at a high temperature of 60° C at a high humidity of 90 %RH for 1000 hr, it does not deteriorate and has excellent sealing properties.

As the heat-sealing thermoplastic resin layer (E), an ionomer resin (polymer of ethylene methacrylic acid metal salt, a melting point of from 80 to 100° C) is used, the moisture getter sheet is put between the gas barrier layer (G) and the heat-sealing thermoplastic resin layer (E) and a heating roll (120° C) is pressed and thereby an organic EL device is prepared. After the organic EL device thus sealed is placed in the same conditions as those of the above, it does not deteriorate for a long period of time and it can be sealed effectively.
Next, in order to prepare the gas barrier film constituting the gas barrier layer of the sealed function element, the gas barrier film is prepared in the following steps of <Preparation of coating solution (X) ) >, <Preparation of coating solution (Y) ) > and < Preparation of coating solution (Z) >.

<Preparation of coating solution (A)>
To zinc acrylate (Zn salt of acrylic acid) aqueous solution (concentration of 30 % by weight, acrylic acid component of 20 % by weight and Zn component of 10 % by weight manufactured by Asada Chemical Industry Co., Ltd.), a photo-polymerization initiator of 25 % by weight of [1-[4-(2-hydroxyethoxy)-phenyl]-2-hydroxy-2-methyl-1- propane-1-on prepared by diluting with methylalcohol (manufactured by Ciba Speciality Chemicals Trade name: Irgacure 2959) and a surface active agent (Trade name Emulgen 120 manufactured by Kao Corporation) are mixed in amounts such that the solid proportions are 2% and 0.4% respectively based on acrylic acid to prepare an unsaturated carboxylic acid compound polyvalent metal salt solution of the acrylic acid Zn salt solution (A).

### <Preparation of coating solution (B)>

Acrylic acid (monomer) (manufactured by Kyoeisha Chemical Co., Ltd.) was diluted with water to prepare a 25% aqueous solution of acrylic acid. Lithium hydroxide hydrate (manufactured by Kanto Chemical Co., Inc.) was added in an equimolecular amount based on carboxyl group of acrylic acid in the aqueous solution to prepare a lithium acrylate (Li salt of acrylic acid) aqueous solution.

To the lithium acrylate aqueous solution, a photo-polymerization initiator of 25 % by weight of [1-[4-(2-hydroxyethoxy)-phenyl]-2-hydroxy-2-methyl-1-propane-1-on prepared by diluting with methylalcohol (manufactured by Ciba Speciality Chemicals Trade name: Irgacure 2959) and a surface active agent (Trade name Emulgen 120 manufactured by Kao Corporation) are mixed in amounts such that the solid proportions are 2% and 0.4% respectively based on acrylic acid to prepare an unsaturated carboxylic acid compound polyvalent metal salt solution of the acrylic acid Li salt solution (B).

### < Preparation of coating solution (C)>

The unsaturated carboxylic acid compound Zn salt solution (A) and the unsaturated carboxylic acid compound Li salt solution (B) were mixed in a molar proportion of 75 to 25 to prepare a coating solution (C).

### Preparation of gas barrier film

A urethane acrylate UV curing coating agent (Trade name: UA-100H manufactured by Shin Nakamura Chemical Co., Ltd.) was diluted with ethyl acetate and applied in an amount of 1.2 g/m² (solid component) on the smooth surface of a substrate having a thickness of 100 µm formed from a biaxial stretched polyethylene naphthalate (Trade name: Teonex Q-65 manufactured by Teijin DuPont Co., Ltd.) by using a Meyer bar and dried at 100° C for 15 sec. Thereafter, the substrate was fixed on a stainless steel plate with the coated surface side up and was polymerized by applying ultraviolet rays at a UV intensity of 250 mW/cm² at an accumulated light of 117 mJ/cm² using a UV irradiation apparatus (EYE GRANDAGE type ECS 301G1 manufactured by Eye graphic Co., Ltd.) to prepare a coated film. On the coated surface of the coated film, a SiN film was formed in a thickness of 75 nm by CatCVD method to prepare a film. The film was subjected to corona treatment and the solution (C) was applied in a solid amount of 1.5 g/m² using a slit die coater on the film. The film was fixed on a stainless steel plate with the coated surface side up and was polymerized by applying ultraviolet rays at a UV intensity of 250 mW/cm² at an accumulated light of 117 mJ/cm² using a UV irradiation apparatus (EYE GRANDAGE type ECS 301G1 manufactured by Eye graphic Co., Ltd.) to prepare a coated film. Thereafter, the coated film was heat-treated in an oven at 200° C for 1 hr to prepare a gas barrier film.
This gas barrier film constitutes the gas barrier layer of the sealed function element of the present invention.

### Drying of gas barrier film

The gas barrier film thus prepared was cut to have a size of 50 mm x 50 mm and dried on a hot plate placed in a glove box at 130° C for 1 hr.

### Drying of heat-sealing film

As the heat-sealing film constituting the heat-sealing thermoplastic resin layer of the sealed function element of the present invention, a heat-sealing film (HM-407C#50 manufactured by Mitsui chemicals Tohcello, Inc.) was used and cut to have a size of 50 mm x 50 mm. The film was put into a glass vessel wound with a band heater and dried by heating at 80° C under reduced pressure with a vacuum pump for 1 hr. Thereafter, while the vessel was kept under reduced pressure, it was placed into a glove box, and the pressure was returned to ordinary pressure.

### Example 1

### Preparation of laminated film for sealing

A dried gas barrier film was cut to have a size of 19 mm x 19 mm and the adhesive surface of a water absorbing material having a size of 10 mm x 10 mm (HD-07 manufactured by Dainic Co. , Ltd.) was adhered on the center of the gas barrier film. Thereafter, the dried heat-sealing film was cut to have a size of 19 mm x 19 mm, superimposed on the water absorbing material adhered surface and laminated with the gas barrier film on a hot plate at 120° C using a hand roller to prepare a laminated film for sealing.

### Sealing of Organic EL

The laminated film for sealing thus prepared was superimposed on a glass substrate on which an organic EL device was formed (substrate size: 24 mm x 24 mm, device part: 2 mm x 2 mm 4 parts, thickness: 0.7 mm) and laminated with the glass substrate on a hot plate at 120° C using a hand roller to prepare a sealed sample.

### Example 2

### Preparation of laminated film for sealing

A dried gas barrier film was superimposed on a dried heat-sealing film and laminated on a hot plate at 120° C using a hand roller, and the laminated film was cut to have a size of 19 mm x 19 mm. On the center part of the laminated film, a water absorbing material for forming a water absorbing layer (HD-07 size: 10 mm x 10 mm manufactured by Dainic Co., Ltd.) was adhered to prepare a laminated film for sealing.

### Formation of filling layer between organic EL device and water absorbing layer

An ultraviolet ray-curing epoxy adhesive (UV resin XNR5570 manufactured by Nagase chemitex Co., Ltd.) was applied to cover the device parts of a glass substrate formed with an organic EL device (substrate size: 24 mm x 24 mm, device parts: 2 mm x 2 mm 4 parts, thickness: 0.7 mm) to form a filling layer. As the ultraviolet ray curing conditions, the luminous intensity was 150 mW/cm² and the accumulated light was 12000 mJ/cm². The filling layer had a thickness of about 30 µm.

### Sealing of organic EL

The laminated film for sealing thus prepared was superimposed on the glass substrate formed with the filling layer and laminated on a hot plate at 120° C using a hand roller to prepare a sealed function element sample.

### Evaluation on sealing properties

The sealed organic EL device was placed in a low-constant temperature and constant moisture apparatus set at 60° C at 90 % RH (THN-052PB manufactured by Advantech Co. Ltd.). At each time, the sample was taken out and the shrunk width was measured by light emitting in a driving condition of 10mA/cm².
The measuring results are shown in Table 1.

**Table 1**

| | Shrunk width (unit: µm) | | | | |
|---|---|---|---|---|---|
| Storage time (unit: hr) | 0 hr | 168 hr | 504 hr | 1008 hr | 1680 hr |
| Example 1 | 4 µm | 4 µm | 4 µm | 8 µm | 16 µm |
| Example 2 | 4 µm | 12 µm | 12 µm | 16 µm | 16 µm |

As is clear from Table 1, in each structure of Example 1 and 2, which are the sealed function element of the present invention, the shrunk width is small so as to be 16 µm after 1680 hr, and it had a sealed structure free from spaces and also good storage properties. Therefore, the panel can be slimed and can have flexibility.

### POSSIBILITY ON INDUSTRIAL USE

The sealed function element of the present invention is sealed by heat-sealing and it can be slimed and can be used for a long period of time. The sealed function element of the present invention can be applied to liquid crystal elements, elements such as organic EL, and other function elements such as sheet-like light emitting devices, light devices and solar cells.

Using the laminated film for sealing (Z) obtainable by laminating the heat-sealing thermoplastic resin layer (E), the water-absorbing layer (F) and the gas barrier layer (G) in this order, the water absorbing agent of the water absorbing layer (F) does not contact with the function element (X) and thereby it can be isolated from the function element. When the sealing of the present invention is applied to organic EL, an element of the organic EL does not directly contact with the water-absorbing layer and thereby the organic EL can be prevented from occurrence of dark spots and can be used for a long period of time. Description of Mark

W ... Substrate layer
X... Function element layer
Y... Filling layer
Z... Laminated film for sealing
E... Heat-sealing thermoplastic resin layer
F... Water absorbing layer
G... Gas barrier layer

## Claims

1. A sealed function element composed of a substrate layer (W), a function element layer (X) and a laminated film for sealing (Z) wherein the substrate layer (W) and a heat-sealing thermoplastic resin layer (E) of the laminated film for sealing (Z) are adhered and unified by heat-sealing.

2. The sealed function element according to claim 1 wherein the laminated film for sealing (Z) comprises a gas barrier layer (G) and the heat-sealing thermoplastic resin layer (E).

3. The sealed function element according to claim 1 or 2 wherein the laminated film for sealing (Z) comprises the heat-sealing thermoplastic resin layer (E), a water-absorbing layer (F) and the gas barrier layer (G) and they are laminated in this order.

4. The sealed function element according to any one of claim 1 to 3 wherein a filling layer (Y) is provided on the side surface and/or the surface of the function element layer (X).

5. The sealed function element according to any one of claim 1 to 4 wherein the substrate layer (W) is a glass substrate.

6. The sealed function element according to any one of claim 1 to 5 wherein the substrate layer (W) comprises a gas barrier film.

7. The sealed function element according to any one of claim 1 to 6 wherein the substrate layer (W) and the periphery part and the whole surface of the laminated film for sealing (Z) are adhered and unified by heat sealing of the heat-sealing thermoplastic resin layer (E).

8. The sealed function element according to any one of claim 1 to 7 wherein the gas barrier film layer comprises a transparent substrate film (Wa), an inorganic thin film layer (Wb) or Wb-free, and a transparent resin layer (Wc) containing a polymer comprising unsaturated carboxylic acid and/or its derivative, and these layers are laminated in this order.
